(19) Europäisches Patentamt
European Patent Office
Office européen des brevets

(11) **EP 2 427 589 B1**

(12) **EUROPÄISCHE PATENTSCHRIFT**

(45) Veröffentlichungstag und Bekanntmachung des Hinweises auf die Patenterteilung:
**20.03.2019 Patentblatt 2019/12**

(21) Anmeldenummer: **10726049.9**

(22) Anmeldetag: **10.06.2010**

(51) Int Cl.:
*C23C 14/34* (2006.01)    *C23C 14/06* (2006.01)
*H01L 35/16* (2006.01)    *H01L 35/22* (2006.01)
*H01L 35/34* (2006.01)

(86) Internationale Anmeldenummer:
**PCT/EP2010/058142**

(87) Internationale Veröffentlichungsnummer:
**WO 2011/000676 (06.01.2011 Gazette 2011/01)**

(54) **VERFAHREN ZUR HERSTELLUNG VON THERMOELEKTRISCHEN SCHICHTEN**

METHOD FOR PRODUCING THERMOELECTRIC LAYERS

PROCÉDÉ DE PRODUCTION DE COUCHES THERMOÉLECTRIQUES

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **30.06.2009 DE 102009031302**

(43) Veröffentlichungstag der Anmeldung:
**14.03.2012 Patentblatt 2012/11**

(73) Patentinhaber: **MAHLE International GmbH**
**70376 Stuttgart (DE)**

(72) Erfinder:
• **TEUNISSEN, Ralph**
**NL-7425 NR Deventer (NL)**
• **SPAN, Gerhard**
**A-6112 Wattens (AT)**

(74) Vertreter: **BRP Renaud & Partner mbB**
**Rechtsanwälte Patentanwälte**
**Steuerberater**
**Königstraße 28**
**70173 Stuttgart (DE)**

(56) Entgegenhaltungen:
**EP-A2- 1 293 769     US-A1- 2006 063 291**

• **DATABASE COMPENDEX [Online] ENGINEERING INFORMATION, INC., NEW YORK, NY, US; Oktober 2002 (2002-10), KOBAYASHI K ET AL: "Fabrication of Bi-Te thermoelectric device by radio frequency sputtering target prepared by MA-PCS process" XP002601124 Database accession no. E2003037326700 & FUNTAI OYOBI FUMMATSU YAKIN/JOURNAL OF THE JAPAN SOCIETY OF POWDER AND POWDER METALLURGY OCTOBER 2002 FUNTAI FUNAMTSU YAKIN KYOKAI/JAPAN SOC. OF POWDER METALLURGY JP, Bd. 49, Nr. 10, Oktober 2002 (2002-10), Seiten 928-932,**
• **DATABASE COMPENDEX [Online] ENGINEERING INFORMATION, INC., NEW YORK, NY, US; Mai 2002 (2002-05), KUSAKABE R ET AL: "Fabrication of (Bi2Te3)0.25(Sb2Te3) 0.75 thermoelectric film by radio frequency sputtering target prepared by MA-PCS process" XP002601125 Database accession no. E2002337050178 & FUNTAI OYOBI FUMMATSU YAKIN/JOURNAL OF THE JAPAN SOCIETY OF POWDER AND POWDER METALLURGY MAY 2002 FUNTAI FUNAMTSU YAKIN KYOKAI/JAPAN SOC. OF POWDER METALLURGY JP, Bd. 49, Nr. 5, Mai 2002 (2002-05), Seiten 412-416,**

- DATABASE INSPEC [Online] THE INSTITUTION OF ELECTRICAL ENGINEERS, STEVENAGE, GB; 2007, MATSUMOTO A ET AL: "Preparation of Fe2VAl thermoelectric module by RF sputtering" XP002601126 Database accession no. 9434950 & MATSUMOTO A ET AL: "Preparation of Fe2VAl thermoelectric module by RF sputtering" MATERIALS SCIENCE FORUM TRANS TECH PUBLICATIONS SWITZERLAND, Bd. 539-543, 2007, Seiten 3285-3289, XP009138845 Switzerland ISSN: 0255-5476
- MIKAMI M ET AL: "Microstructure and thermoelectric properties of Heusler Fe2VAl thin-films" THIN SOLID FILMS, ELSEVIER-SEQUOIA S.A. LAUSANNE, CH LNKD-DOI:10.1016/J.TSF.2009.08.029, Bd. 518, Nr. 10, 1. März 2010 (2010-03-01) , Seiten 2796-2800, XP026903611 ISSN: 0040-6090 [gefunden am 2009-08-23] & MIKAMI M ET AL: "Synthesis and thermoelectric properties of microstructural Heusler Fe2VAl alloy" JOURNAL OF ALLOYS AND COMPOUNDS, ELSEVIER SEQUOIA, LAUSANNE, CH LNKD-DOI:10.1016/J.JALLCOM.2007.07.004, Bd. 461, Nr. 1-2, 11. August 2008 (2008-08-11), Seiten 423-426, XP022708746 ISSN: 0925-8388 [gefunden am 2008-06-07]

**Beschreibung**

Die Erfindung betrifft ein Verfahren zur Herstellung von thermoelektrischen Schichten durch Abscheiden von thermoelektrischem Material auf einem Substrat im Wege der Sputterdeposition.

Thermoelektrische Schichten mit unterschiedlichen thermoelektrischen Materialien werden zur Nutzung der Thermoelektrizität benötigt. Der thermoelektrische Effekt, auch als Seebeck-Effekt bezeichnet, beschreibt die umkehrbare Wechselwirkung zwischen Temperatur und Elektrizität. Die Seebeck-Spannung wird bestimmt durch:

$$U_{Seebeck} = \alpha \ x \ \delta T$$

mit
$\delta T$ Temperaturdifferenz zwischen heißer und kalter Seite $\alpha$ - Seebeck - Koeffizient bzw. Thermokraft

Der Seebeck-Koeffizient hat die Dimension einer elektrischen Spannung pro Temperaturdifferenz (V/K). Die Größe des Seebeck-Koeffizienten ist maßgeblich für die Höhe der Seebeck-Spannung verantwortlich.

Thermoelemente mit zwei unterschiedlichen an einem Ende miteinander verbundenen Metallen wandeln thermische Energie nur sehr ineffizient in elektrische Energie um. Für thermoelektrische Generatoren kommen daher andere thermoelektrische Materialien, insbesondere Halbleitermaterialien, wie insbesondere $Bi_2Te_3$, $Bi_2Se_3$, $Sb_2Te_3$, $PbTe$, $SiGe$ oder $FeSi_2$ und deren Legierungen zum Einsatz.

Heute verfügbare Thermogeneratoren haben dennoch nur einen verhältnismäßig geringen Wirkungsgrad; er beträgt nur ein Bruchteil (ca. 17 %) des Carnot-Wirkungsgrades.

Neben den herkömmlichen, zwischen Platten angeordneten quaderförmigen thermoelektrischen Materialien offenbart die DE 101 22 679 A1 bereits in Dünnschicht vorliegende thermoelektrische Materialien zur Herstellung von thermoelektrischen Generatoren.

Die Herstellung thermoelektrischer Schichten erfolgt nach dem Stand der Technik durch reaktives Sputtern, bei dem die chemischen Reaktionen nicht zwischen einem Reaktivgas und den chemischen Elementen aus den Targets stattfinden, sondern die chemischen Elemente aus den Targets bilden eine chemische Verbindung. Bei dem reaktiven Sputtern werden aus unterschiedlichen Targets die Elemente Bismut, Tellur, Selen und Antimon herausgelöst und auf einem Substrat in dem Reaktionsraum abgeschieden. Als Ionenquelle dient zumeist eine Gleichstrom-Gasentladung in einem Reaktionsraum, um entsprechende Verbindungen der Einzelelemente Bismut, Tellur, Selen und Antimon auf dem Substrat zu deponieren.

Beim diesem reaktiven Sputtern entstehen die chemischen Verbindungen in exothermen Reaktionen sowohl in der Sputterkammer als auch auf dem Substrat, was durch den zusätzlichen Wärmeeintrag zu einer in-situ Wärmebehandlung (Tempern) führt, wodurch weniger Korngrenzen in den thermoelektrischen Schichten entstehen. Der durch diese Art von reaktivem Sputtern erzielbare Seebeck-Koeffizient der abgeschiedenen Schichten aus thermoelektrischem Material und damit der Wirkungsgrad eines derart hergestellten Thermogenerators sind daher nicht optimal.

Die Herstellung der Festkörper-Targets aus den chemischen Elementen Bismut, Tellur, Selen und Antimon erfolgt durch einen Heißpress-Prozess, wie er zur Herstellung derartiger Sputtertargets an sich bekannt ist. In der WO 2007/042255 A1 wird ein derartiges Heißpress-Verfahren zur Herstellung eines Sputtertargets offenbart, das allerdings nicht zur Herstellung thermoelektrischer Schichten, bestimmt ist.

Die EP 1 737 053 A1 offenbart ein Verfahren zur Herstellung thermoelektrischer Schichten mittels Sputtern eines durch Vermischen mehrerer Komponenten hergestellten Targets. Mit dem zur Gruppe der PVD- Verfahren gehörigen herkömmlichen Sputtern wird ein hoher Kristallisationsgrad angestrebt, um gute thermoelektrische Eigenschaften in der abgeschiedenen Dünnschicht zu erhalten, die insbesondere als Einkristall-Dünnschicht erzeugt wird. Der hohe Kristallisierungsgrad in der thermoelektrischen Schicht bewirkt eine Zunahme der Leitfähigkeit. Der Kristallisationsgrad ist jedoch stark von der Schichtdicke abhängig. Mit wachsender Schichtdicke nimmt der Kristallisationsgrad ab. Damit ergibt sich eine maximale, recht geringe Schichtdicke für den besten Kristallisationsgrad, die gemäß der Lehre der EP 1 737 053 A1 vorzugsweise auf 5 $\mu m$ beschränkt wird, um gute thermoelektrische Eigenschaften zu erhalten. Dünne Schichten haben jedoch den Nachteil, dass die aus diesen hergestellten thermoelektrische Generatoren keine hohen Leistungen abgeben können, da der Stromfluss durch die dünnen Schichten begrenzt ist.

Aus der US 2006/063291 A1 ist ein Verfahren zur Herstellung von thermoelektrischen Schichten durch Abscheiden von thermoelektrischem Material auf einem Substrat im Wege der Sputterdeposition bekannt. Zur Herstellung eines Targets wird eine SiGe-Legierung in einer Planetenkugelmühle zu Teilchen mit wenigen Mikron pulverisiert und anschließend gesintert. Unter Verwenung des Targets wird ein Film aus SiGe mit einem Hochfrequenz-Sputtergerät hergestellt. Der Film hat ein Dicke von ungefähr 0,7 Mikrometer.

Ausgehend von diesem Stand der Technik liegt der Erfindung die Aufgabe zu Grunde, ein Verfahren zur Herstellung thermoelektrischer Schichten zu schaffen, die für den Einsatz in Thermogeneratoren besser geeignet sind, insbesondere höhere Seebeck-Koeffizienten aufweisen. Des Weiteren soll die Herstellung der Targets vereinfacht werden.

Diese Aufgabe wird bei einem Verfahren der eingangs erwähnten Art dadurch gelöst, dass die Herstellung eines Targets im Wege des mechanischen Legierens oder im Wege des Plasmalegierens aus thermoelektrischem Material durch Vermischen von mindestens zwei pulverförmigen Ausgangsmaterialien in einer Partikelgröße von 0,01 $\mu$m - 5000,00 $\mu$m unter Energieeinkopplung sowie das Abscheiden des thermoelektrischen Materials aus dem Target auf dem Substrat im Wege der Magnetron-Sputterdeposition erfolgt, wobei ein magnetisches Feld das von einer Targetkathode und einer Anode erzeugte elektrische Feld überlagert und eine Gleichstromgasentladung zwischen der Targetkathode und der Anode als Ionenquelle dient.

Durch die Herstellung eines Targets aus thermoelektrischem Material entfällt die Notwendigkeit, mehrere Targets der Einzelelemente vom Typ Bismut, Tellur, Selen und Antimon herzustellen. Die Herstellung der thermoelektrischen Targets erfolgt durch Vermischen von mindestens zwei pulverförmigen Ausgangsmaterialien in einer Partikelgröße von 0,01 $\mu$m - 5000,00 $\mu$m, insbesondere von 0,5 $\mu$m bis 150$\mu$m unter Energieeinkopplung. Die Herstellung des Targets aus thermoelektrischem Material erlaubt darüber hinaus den Übergang zu der Magnetron-Sputterdeposition.

Erfindungsgemäß erfolgt die Abscheidung der thermoelektrischen Materialien im Wege der Magnetron-Sputterdeposition aus dem zuvor hergestellten Target. Die Magnetron-Sputterdeposition führt abweichend zu dem bisher angestrebten hohen Kristallisationsgrad zu einem niedrigeren Kristallisationsgrad. Überraschend hat sich jedoch gezeigt, das die Anzahl der Korngrenzen zwischen den Kristallen steigt, wodurch trotz des geringen Kristallisationsgrades der Seebeck-Koeffizient in den thermoelektrischen Schichten steigt und damit der Wirkungsgrad eines aus den thermoelektrischen Schichten hergestellten thermoelektrischen Generators verbessert wird.

Die Erfindung nutzt die hohen Wachstumsraten beim Magnetron-Sputtern um durch eine Nanostrukturierung der abgeschiedenen thermoelektrischen Schichten deren thermoelektrische Eigenschaften zu verbessern. Aufgrund der vielen Defekte und Korngrenzen und dem geringen Abstand dieser Kristallfehler werden die Materialeigenschaften der abgeschiedenen Schichten derart verändert, dass der Seebeck-Koeffizient sogar über den Wert eines Einkristalls steigt. Auch die elektrische und thermische Leitfähigkeit werden durch die Nanostrukturierung erhöht, so dass sich die thermoelektrischen Eigenschaften des abgeschiedenen Materials verbessern.

Durch das erfindungsgemäß eingesetzte Magnetron-Sputtern wird die bisherige Beschränkung der Dicke der thermoelektrischen Schichten aufgehoben, so dass deutlich größere Ströme und damit höhere Leistungen von den Schichten erzeugt werden können. Die dickeren Schichten können ohne Einbuße der thermoelektrischen Eigenschaften des abgeschiedenen Materials abgeschieden werden.

Ein weiterer Vorteil der Magnetron-Sputterdeposition besteht darin, dass eine Entmischung der Legierung aus den Ausgangsmaterialien vermieden wird. Außerdem ist die Haftung und Homogenität der Schicht auf dem Substrat besser als beim reaktiven Sputtern.

Die Magnetron-Sputterdeposition wird mit einer Magnetronsputter-Anlage durchgeführt, bei der hinter der Kathodenplatte Magnete zur Erzeugung eines Magnetfeldes angeordnet sind. Durch die Überlagerung von elektrischem und magnetischem Feld bewegen sich die Ladungsträger nicht parallel zu den elektrischen Feldlinien, sondern werden auf eine Zykloidbahn gelenkt. Die hieraus resultierende längere Wegstrecke der Elektronen führt zu einer höheren Anzahl an Stößen mit den Edelgas-Atomen, damit zu einer höheren Ionisation des Edelgases und somit zur Erhöhung der Sputterrate. Es wird mehr thermoelektrisches Material von dem Target bei gleichem Prozessdruck auf dem Substrat abgeschieden. Da das Schichtwachstum und somit die Schichteigenschaften neben der Temperatur vor allem vom Prozessdruck innerhalb des Reaktionsraums der Magnetronsputter-Anlage abhängig sind, kann man bei gleichen Wachstumsraten den Prozessdruck deutlich geringer als bei herkömmlichem reaktiven Sputtern wählen (bis zu 100 x geringer). Dies führt zu einer dichteren, weniger porösen thermoelektrischen Schicht auf dem Substrat, da weniger Gasatome in die Schichten mit eingebaut werden. Damit neigen die daraus resultierenden Schichten weniger zur Versprödung aufgrund des Einbaus von Fremdatomen in das Kristallgitter bzw. in die Korngrenzen (interstitielle Atome).

Zur Herstellung des Targets werden vorzugsweise mindestens zwei unterschiedliche Ausgangsmaterialien in einer Partikelgröße von 0,01 $\mu$m - 5000,00 $\mu$m, insbesondere 0,5 $\mu$m bis 150 $\mu$m unter Energieeinkopplung aus den nachfolgend genannten Ausgangsmaterialien vermischt, so dass ein schichtartiger Aufbau der Ausgangsmaterialien entsteht bzw. die Partikel des ersten Ausgangsmaterials zumindest teilweise von dem zweiten Ausgangsmaterial benetzt werden.

Die derartig hergestellten Sputtertargets ergeben optimale thermoelektrische Schichten, wenn folgende Zusammensetzungen und Ausgangsmaterialien verwendet werden:

- p-Typ Target mit der derzeit optimalen Zusammensetzung 25 mol-% $Bi_2Te_3$ (Bismut-Tellurid) - 75 mol-% $Sb_2Te_3$ (Antiomon-Tellurid) oder $(Bi_{0,25}Sb_{0,75})_2Te_3$, wobei die Zusammensetzung im Bereich von 60 - 90 mol-% $Sb_2Te_3$ und dementsprechend 10 - 40 mol% $Bi_2Te_3$ variiert werden kann.
- n-Typ Target mit optimaler Zusammensetzung 90 mol% $Bi_2Te_3$ (Bismut Tellurid) und 10 mol% $Bi_2Se_3$ (Bismut-Selenid) oder $Bi_2(Te_{0,9}Se_{0,1})_3$ mit Variation der Zusammensetzung im Bereich von 5 - 20 mol% $Bi_2Se_3$ und ent-

sprechend 80 - 95 mol% $Bi_2Se_3$.

- Si und Ge mit Zusammensetzungen im Bereich von 65 - 95 mol% Silizium und 5 - 35% Germanium. Siliziumgermanium muss noch dotiert werden, so dass man zwei unterschiedliche Targets erhält, eines vom n-Typ und eines vom p-Typ. Da Dotierung bedeutet, dass ein Dotierstoff in niedriger Konzentration beigegeben wird (< 1%); hierdurch ändern sich die grundlegenden Eigenschaften des Siliziumgermanium nicht, nur die elektronischen Eigenschaften werden beeinflusst.

  Zur Herstellung eines p-Typ Targets werden die p-Typ dotierten Ausgangsmaterialien Silizium und Germanium vermischt. Als Dotierstoffe können verwendet werden: B, Al, Ga, In.

  Zur Herstellung eines n-Typ Targets werden die n-Typ dotierten Ausgangsmaterialien Silizium und Germanium vermischt. Als Dotierstoffe können verwendet werden: P, As, Sb
- Karbide, v. a. $B_4C$, $B_9C$ und SiC, das sind Verbindungshalbleiter mit großer Bandlücke für Anwendungen bei hohen Temperaturen.
- Clathrate, v.a. basierend auf Germanium und Silizium, z.B. $BagGe_{43}$, $(Ba, Sr)_8Ga_{10}Ge_{30}$, $Cs_8Na_{16}Si_{136}$, $Cs_8Na_{16}Ge_{136}$, $Rb_8Na_{16}Si_{136}$ oder $Rb_8Na_{16}Ge_{136}$. Diese Materialien bilden eine Käfigstruktur aus Silizium oder Germanium, die ein oder mehrere Atome im inneren Hohlraum enthalten.
- Nitride, z.B. GaN, AlN, InN, SiN, das sind Verbindungshalbleiter, die mit großer Bandlücke für Anwendungen bei hohen Temperaturen. Derzeit werden diese Materialien für optoelektronische Bauteile, z.B. blaue LEDs verwendet. In der reinen, nichtleitenden Form werden diese Materialien auch als Funktionskeramiken eingesetzt.
- Skutterudite, z.B. $CoSb_3$. Diese Materialen haben eine gemeinsame Kristallstruktur, die ebenfalls als eine Käfigstruktur betrachtet werden kann, in die Atome eingeschlossen werden können und damit die thermische Leitfähigkeit erniedrigt wird.
- Perovskite haben eine Elementarzelle, die als geschichtet betrachtet werden kann. Dies führt zu niedrigen thermischen Leitfähigkeiten oder zu Supraleitfähigkeit, je nach den enthaltenen Atomen. Materialien sind z.B. $LaCoO_3$, $La_{1-x}Sr_xCoO_3$, $Bi_2Ca_2Co_2O_x$, $NaCo_2O_4$, $Ca_3Co_4O_9$, $Ca_3Co_2O_6$
- Zintl Phasen bieten auch gute Eigenschaften für thermoelektrische Anwendungen aufgrund ihrer chemischen Bindungen, die zu einer Elementarzelle mit geringer Ordnung und damit hoher Streurate für Phononen führt. Materialien sind z.B. $Zn_4Sb_3$, $Ca_{11}GaSb_9$, $CaZn_2Sb_2$ und $BaGa_2Sb_2$.
- Half-Heusler Verbindungen, z.B. AgAsMg oder AlLiSi. Die Verbindung von leichten und schweren Atomen innerhalb der Elementarzelle behindert den ungestörten Transport von Phononen und führt damit zu niedrigen thermischen Leitfähigkeiten.
- Kohlenstoff basierte Halbleiter, z.B. CNT, Graphen. Diese Materialien bilden dünne Schichten, in denen die quantenmechanischen Eigenschaften der Elektronen zu deutlich anderen Eigenschaften als dem Kohlenstoff führen. Diese Eigenschaften erhöhen die elektrische Leitfähigkeit und/oder den Seebeck Koeffizienten und bieten daher eine gute Ausgangsposition für thermoelektrische Bauteile.
- Metalloxide, v.a. Titanoxid, mit variierendem Anteil von Sauerstoff, um die Dotierung und Typ des Halbleiters festzulegen.

Ein besonders vorteilhaftes Verfahren zur Herstellung des Targets aus thermoelektrischem Material umfasst folgende Schritte:

- Mahlen der mindestens zwei pulverförmigen Ausgangsmaterialien,
- Entnehmen der durch das Mahlen legierten Ausgangsmaterialien und
- anschließendes Sintern der legierten Ausgangsmaterialien bei Temperaturen im Bereich von 200 - 1000 ° C, je nach Material

Das Mahlen der mindestens zwei pulverförmigen Ausgangsmaterialien erfolgt insbesondere mit Hilfe einer Mahlkörpermühle, vorzugsweise einer Kugel- oder Jetmühle. In der Mahlkörpermühle werden die Mahlkörper und die pulverförmigen Ausgangsmaterialien als Mahlgut bewegt. Das Mahlgut wird zerkleinert, wenn es sich zwischen den Mahlkörpern befindet. Dies geschieht durch Prall- und Stoßbeanspruchung. Hierdurch kommt es zu einer intensiven Vermischung der pulverförmigen Ausgangsmaterialien. Der Energieeintrag erfolgt durch die Prall- und Stoßbeanspruchung. Das Mahlen der pulverförmigen Ausgangsmaterialien wird auch als mechanisches Legieren bezeichnet. In Folge der lokal erhöhten Temperaturen während des Mahlens kann zumindest eines der Ausgangsmaterialien zum Teil in geschmolzener Form vorliegen und so den schichtartigen Aufbau ausbilden bzw. die Partikel des anderen Ausgangsmaterials benetzen.

Nach dem Mahlen werden die pulverförmigen Ausgangsmaterialien gesintert. Das Sintern umfasst das Verpressen der gemahlenen Ausgangsmaterialien zu einer Struktur, dem so genannten Grünling. Durch Sintern dieser Struktur bei Temperaturen im Bereich von 200 bis 1000 Grad C° wird die Struktur bei etwa 60 - 80 % der Schmelztemperatur zu dem Target ausgehärtet

Eine Beschleunigung des mechanischen Legierens kann in vorteilhafter Ausgestaltung der Erfindung dadurch erreicht werden, dass während des Mahlens von mindestens zwei pulverförmigen Ausgangsmaterialien Wärme zugeführt wird.

Alternativ kann das Target aus thermoelektrischem Material im Wege des so genannten Plasmalegierens aus den mindestens zwei pulverförmigen Ausgangsmaterialien hergestellt werden. Hierzu werden die pulverförmigen Ausgangsmaterialien zunächst in einen Gasstrom, insbesondere aus Luft, Argon, Stickstoff, Wasserstoff oder Sauerstoff oder Mischungen der vorgenannten Gase, eingebracht und dort vermischt. Der die Ausgangsmaterialien tragende Gasstrom wird in den Gasstrahl eines kalten atmosphärischen Plasmas eingespeist. Dabei kommt es bei einer Temperatur des kalten atmosphärischen Plasmas unterhalb von 1000 Grad C° zu der Legierung der beiden Ausgangsmaterialien, wobei der bereits beschriebene schichtartige Aufbau der Ausgangsmaterialien bzw. die Benetzung des einen Ausgangsmaterials mit dem anderen Ausgangsmaterial erfolgt. Ein vorteilhafter Massestrom der Ausgangsmaterialien in dem eingespeisten Gasstrom liegt im Bereich von 0,01 bis 200 g/sec cm$^2$.

Eine weitere Verbesserung des Seebeck-Koeffizienten der abgeschiedenen thermoelektrischen Schicht wird in einer Ausgestaltung des erfindungsgemäßen Verfahrens dadurch erreicht, dass die Schicht bei einer Temperatur im Bereich von 200 Grad C° bis 1000 Grad C°, abhängig von den verwendeten Ausgangsmaterialien, getempert wird.

Dabei bedeutet "Tempern", dass die Schicht auf eine Temperatur unterhalb von deren Schmelztemperatur über einen längeren Zeitraum, im Allgemeinen zwischen 30 min und einigen Stunden, erhitzt wird, wobei Strukturdefekte ausgeglichen werden und die Struktur der Kristalle verbessert wird.

Es wird angenommen, dass vor der Rekristallisierung (oder dem Kristallwachstum) die Schichten derartig nanostrukturiert sind, dass Kristallite nur einige nm groß sind und daher die Korngrenzen (die unstrukturierte Umgebung der Kristallite) ebenfalls eine Überstruktur mit einer Periodenlänge von einigen nm bilden. In dieser Größenskala tritt die quantenmechanische Natur des Ladungstransportes stark zu Tage und es bildet sich neben dem Ladungstransport in Leitungs- und Valenzband innerhalb der Kristallite auch ein Leitfähigkeitsmechanismus basierend auf dem "Hopping", bei dem lokalisierte quantenmechanische Zustände aufgrund der kleinen Abstände sich miteinander verschränken und ein durchgängiges "Quasiband" bilden. Dieses Quasiband hat metallische Eigenschaften im Unterschied zu den Halbleitereigenschaften (Isolator) innerhalb der Kristallite, womit zwei unterschiedlichen Phasen, eine metallische und eine halbleitende, gebildet werden. Beim Tempern vergrößern sich die Kristallite (Rekristallisation) und der Abstand zwischen den Korngrenzen steigt. Damit sinkt die Effizienz des Hoppingmechanismus und die Halbleitereigenschaften der Materialien treten in den Vordergrund. Der Hoppingmechanismus verändert die Zustandsdichte von Elektronen und Löchern dergestalt, dass der Seebeck-Koeffizient größer wird.

Nachfolgend wird das erfindungsgemäße Verfahren anhand der Figuren 1 bis 3 näher erläutert.

**Figuren 1 A)- C)**     veranschaulichen die Herstellung eines Targets aus thermoelektrischem Material im Wege des mechanischen Legierens;

**Figuren 2 A) - B)**     veranschaulichen die Herstellung eines Targets aus thermoelektrischem Material im Wege des Plasmalegierens;

**Figuren 3 A) - C)**     zeigen das Einbringen des Targets in den Magnetron-Sputter, das Abscheiden des thermoelektrischen Materials im Wege der Magnetron-Sputterdeposition sowie das anschließende Tempern der auf dem Substrat abgeschiedenen thermoelektrischen Schicht.

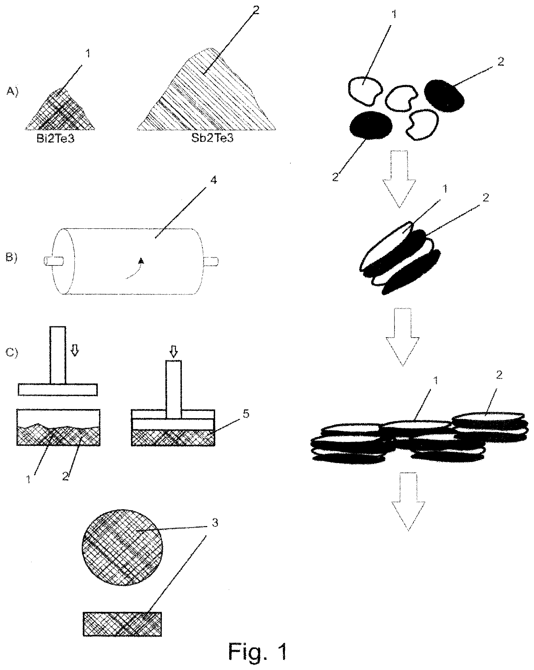

Figur 1 A) zeigt als erstes Ausgangsmaterial (1) Bismut-Tellurid $Bi_2Te_3$ und als zweites Ausgangsmaterial (2) Antimon-Tellurid $Sb_2Te_3$. Zur Herstellung eines Targets (3) aus thermoelektrischem Material werden die beiden Ausgangsmaterialien (1, 2) in einer Zusammensetzung von 25 mol-% Bismut-Tellurid $Bi_2Te_3$ und 75 mol-% Antimon-Tellurid $Sb_2Te_3$ in eine Kugelmühle (4) (Figur 1 B))gegeben, wo die beiden Ausgangsmaterialien (1, 2) in der Kugelmühle gemahlen werden. Durch das mechanische Legieren ergibt sich der schichtartige, in der rechten Bildhälfte von Figur 1 B) erkennbare Aufbau der Ausgangsmaterialien (1,2) in Agglomeraten, die sich in der Kugelmühle (4) während des mechanischen Legierens bilden.

Anschließend werden die durch das Mahlen legierten Ausgangsmaterialien (1, 2), wie in Figur 1 C) dargestellt, einem Sinterprozess zugeführt. Hierzu werden die legierten Ausgangsmaterialien (1, 2) zu einer Struktur (5) verdichtet und unterhalb der Schmelztemperatur der legierten Ausgangsmaterialien (1, 2) ausgehärtet.

In der linken Bildhälfte der Figur 1 c) sind schließlich die zu dem Target (3) verdichteten und ausgehärteten Ausgangsmaterialien erkennbar.

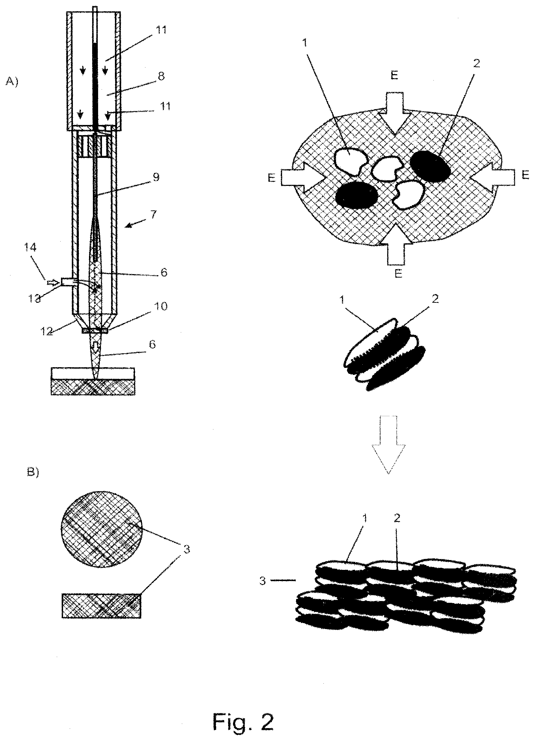

Figuren 2 A), B) zeigen die Herstellung des Targets (3) aus dem ersten Ausgangsmaterial (1) und dem zweiten Ausgangsmaterial (2) im Wege des Plasmalegierens.

Zur Erzeugung des hierzu erforderlichen kalten atmosphärischen Plasmas in einem Gasstrahl (6) dient ein hohlzylindrischer Plasmaerzeuger (7) an dessen Stirnseite eine Zufuhr (8) für ein Arbeitsgas angeordnet ist. Von dieser Stirnseite erstreckt sich mittig eine Stiftelektrode (9) in den Plasmaerzeuger (7). An der gegenüberliegenden Stirnseite, des sich düsenartig verjüngenden Plasmaerzeugers (7) befindet sich eine Ringelektrode (10). Zwischen der Stift- und Ringelektrode (9, 10) liegt eine Zündspannung an, die zu einem Überschlag und dem Zünden einer Gasentladung zwischen den Elektroden (9,10) führt. In dem in Richtung der Pfeile (11) durch den Plasmaerzeuger (7) strömenden Arbeitsgas wird das kalte atmosphärische Plasma in dem Gasstrahl (6) erzeugt.

Querab zur Strömungsrichtung (11) des Arbeitsgases befindet sich in dem Plasmaerzeuger (7) nahe dessen sich düsenförmig verjüngender Spitze (12) ein Einlass (13) zum Einspeisen eines weiteren Gasstroms (14) in den Plasmaerzeuger (7). Der Gasstrom (14) enthält die beiden pulverförmigen Ausgangsmaterialien (1, 2), die zuvor in diesen eingebracht und durch den Transport im Gasstrom vermischt werden. In den Gasstrahl (6) wird das erste und zweite pulverförmige Ausgangsmaterial (1, 2) mit dem Gasstrom (14) eingebracht. Durch die Energieeinkopplung E in dem Gasstrahl (6) des Plasmaerzeugers wird die in der rechten Bildhälfte von Figur 1 A) erkennbare schichtartige Struktur der Ausgangsmaterialien (1, 2) erzeugt und das in Figur 1 B) dargestellte Target (3) erzeugt. Die Abscheidung der Ausgangsmaterialien erfolgt insbesondere auf einem Träger aus Kupfer, der als Targetkathode in der Magnetronsputter-Anlage (17) geschaltet wird.

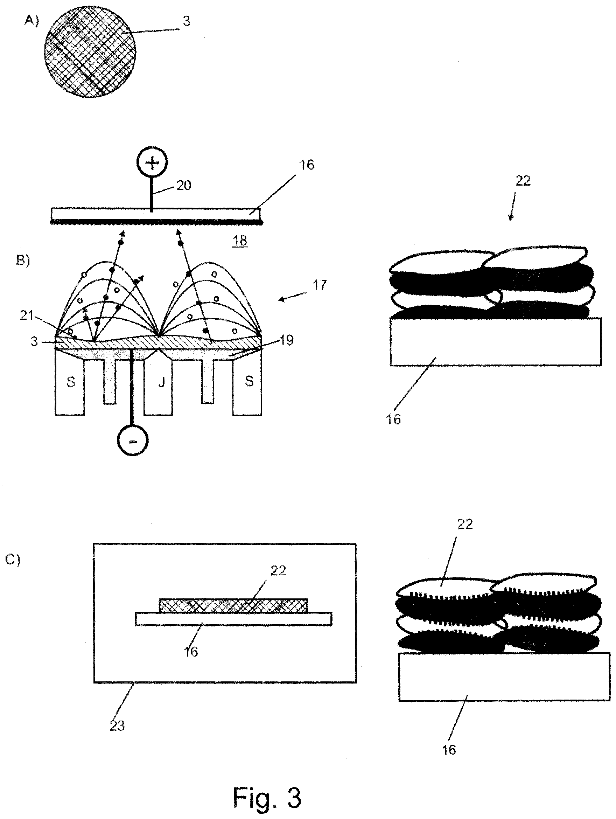

Figur 3 A) zeigt das Target (3), das entweder im Wege des mechanischen Legierens entsprechend Figur 1 oder im Wege des Plasmalegierens entsprechend Figur 2 hergestellt wurde.

Das thermoelektrische Material aus dem Target (3) wird auf einem Substrat (16) im Wege der Magnetron-Sputterdeposition abgeschieden. Die hierzu erforderliche Magnetronsputter-Anlage (17) umfasst einen evakuierten Arbeitsraum (18), in dem ein Edelgas, insbesondere Argon, zum Einsatz gelangt. Auf einer Seite des Arbeitsraums befindet sich die Targetkathode (19), die vorzugsweise plattenförmig ausgebildet ist. In die Nähe des auf der Targetkathode (19) befindlichen Targets (3) wird das Substrat (16) gebracht, so dass die aus dem Target (3) durch Beschuss mit energiereichen Edelgasionen herausgelösten Atome in die Gasphase übergehen und auf dem Substrat (16) kondensieren und die Schicht (22) mit thermoelektrischem Material bilden können.

Als Ionenquelle dient eine Gleichstromgasentladung zwischen der Targetkathode (19) und der Anode (20). Hinter der Targetkathode (19) befinden sich Magnete zur Ausbildung eines zusätzlichen Magnetfeldes. Das magnetische Feld überlagert das von der Targetelektrode (19) und der Anode (20) erzeugte elektrische Feld. Hierdurch wird eine höhere Ionisation im Bereich parallel zur Oberfläche (21) des Targets (3)erzeugt.

Schließlich wird entsprechend Figur 3 c) in einem letzten Schritt die auf dem Substrat (16) abgeschiedene thermoelektrische Schicht (22) in einem Temperofen (23) bei einer Temperatur von 200 Grad C° bis 1000 Grad C° abhängig von dem thermoelektrischen Material des Targets (3) getempert. Die Temperatur ist beim Tempern so zu bestimmen, dass die thermoelektrische Schicht (22) stets auf eine Temperatur unterhalb der Schmelztemperatur der Schicht erhitzt wird. Sofern Bismut-Tellurid eines der Ausgangsmaterialien ist, erfolgt das Tempern bei 200 bis 400 Grad C°. Sofern Skutterudite und Clathrate die Ausgangsmaterialien des thermoelektrischen Materials darstellen, erfolgt das Tempern in einem Temperaturbereich zwischen 500 bis 700 Grad C°. Sofern Silizium und Germanium oder Perowskite die Ausgangsmaterialien des thermoelektrischen Materials sind, erfolgt das Tempern in einem Temperaturbereich zwischen 800 bis 1000 Grad C°.

Durch ein optimiertes Temperaturprofil während des Temperns, kann die Rekristallisation so gesteuert werden, dass der Seebeck-Koeffizient der abgeschiedenen thermoelektrischen Schicht (22) größer als der Seebeck-Koeffizient der reinen kristallinen thermoelektrischen Materialien ist.

**Bezugszeichenliste**

| Nr. | Bezeichnung |
| --- | --- |
| 1 | erstes Ausgangsmaterial |
| 2 | zweites Ausgangsmaterial |
| 3 | Targets |
| 4 | Kugelmühle |
| 5 | Struktur |
| 6 | Gasstrahl (Plasma) |
| 7 | Plasmaerzeuger |
| 8 | Zufuhr |
| 9 | Stiftelektrode |
| 10 | Ringelektrode |

(fortgesetzt)

| Nr. | Bezeichnung |
|---|---|
| 11 | Strömungsrichtung |
| 12 | Spitze |
| 13 | Einlass |
| 14 | Gasstrom |
| 15 | -- |
| 16 | Substrat |
| 17 | Magnetron-Sputterdepositionsanlage |
| 18 | Arbeitsraum |
| 19 | Targetelektrode |
| 20 | Anode |
| 21 | Oberfläche - (Target (3)) |
| 22 | thermoelektrischer Schicht |
| 23 | Temperofen |

## Patentansprüche

1. Verfahren zur Herstellung von thermoelektrischen Schichten durch Abscheiden von thermoelektrischem Material auf einem Substrat im Wege der Sputterdeposition, **gekennzeichnet durch**

   - die Herstellung eines Targets aus thermoelektrischem Material durch Vermischen von mindestens zwei pulverförmigen Ausgangsmaterialien (1,2) in einer Partikelgröße von 0,01 $\mu$m - 5000,00 $\mu$m unter Energieeinkopplung im Wege des mechanischen Legierens oder im Wege des Plasmalegierens sowie
   - das Abscheiden des thermoelektrischen Materials aus dem Target (3) auf dem Substrat im Wege der Magnetron-Sputterdeposition, wobei ein magnetisches Feld das von einer Targetkathode (19) und einer Anode (20) erzeugte elektrische Feld überlagert und eine Gleichstromgasentladung zwischen der Targetkathode (19) und der Anode (20) als Ionenquelle dient.

2. Verfahren nach Anspruch 1, **dadurch gekennzeichnet, dass** zur Herstellung des Targets (3) mindestens zwei unterschiedliche Ausgangsmaterialien (1,2) aus einer der nachfolgenden Gruppen von Ausgangsmaterialien vermischt werden:

   - $Bi_2Te_3$, $Bi_2Se_3$, $Sb_2Te_3$,
   - Pb, Te
   - Si, Ge,
   - Karbide,
   - Perovskite
   - Clathrate
   - Skutterudite
   - Nitride,
   - Zintl Phasen,
   - Half-Heusler-Verbindungen,
   - Kohlenstoff basierten Halbleiter und
   - Metalloxide

3. Verfahren nach Anspruch 2, **dadurch gekennzeichnet, dass** zur Herstellung eines p-Typ Targets (3) die Ausgangsmaterialien $Sb_2Te_3$ und $Bi_2Te_3$ vermischt werden, wobei das p-Typ Target 60 - 90 mol-% Bezeichnung $Sb_2Te_3$ aufweist.

**4.** Verfahren nach Anspruch 2, **dadurch gekennzeichnet, dass** zur Herstellung eines n-Typ Targets (3) die Ausgangsmaterialien Bezeichnung $Bi_2Se_3$ und $Bi_2Te_3$ vermischt werden, wobei das n-Typ Target 80 - 95 mol-% $Bi_2Se_3$ aufweist.

**5.** Verfahren nach Anspruch 2, **dadurch gekennzeichnet, dass** zur Herstellung eines n-Typ Targets die n-Typ dotierten Ausgangsmaterialien Silizium und Germanium vermischt werden.

**6.** Verfahren nach Anspruch 2, **dadurch gekennzeichnet, dass** zur Herstellung eines p-Typ Targets die p-Typ dotierten Ausgangsmaterialien Silizium und Germanium vermischt werden.

**7.** Verfahren nach einem der Ansprüche 1 bis 6, **dadurch gekennzeichnet, dass** die Herstellung des Targets (3) aus thermoelektrischem Material folgende Schritte umfasst:

- Mahlen der mindestens zwei pulverförmigen Ausgangsmaterialien (1,2),
- Entnehmen der durch das Mahlen legierten Ausgangsmaterialien und
- anschließendes Sintern der legierten Ausgangsmaterialien bei Temperaturen im Bereich von 200 - 1000 ° C.

**8.** Verfahren nach Anspruch 7, **dadurch gekennzeichnet, dass** die mindestens zwei pulverförmigen Ausgangsmaterialien (1,2) in einer Mahlkörpermühle (4) gemahlen werden.

**9.** Verfahren nach einem der Ansprüche 1 bis 6, **dadurch gekennzeichnet, dass** die Herstellung des Targets aus thermoelektrischem Material folgende Schritte umfasst:

- Einbringen der mindestens zwei pulverförmigen Ausgangsmaterialien (1,2) in einen Gasstrom (14),
- Erzeugen eines kalten atmosphärischen Plasmas in einem Gasstrahl (6),
- Einspeisen des Gasstroms (14) in den Gasstrahl (6) und
- Abscheiden der Ausgangsmaterialien (1,2) auf einem Träger.

**10.** Verfahren nach Anspruch 9, **dadurch gekennzeichnet, dass** das kalte atmosphärische Plasma eine Temperatur unterhalb von 1000 ° C aufweist.

**11.** Verfahren nach Anspruch 9 oder 10, **dadurch gekennzeichnet, dass** der Massestrom der Ausgangsmaterialien (1,2) in dem Gasstrom im Bereich von 0,01 - 200 g/sec cm$^2$ liegt.

**12.** Verfahren nach einem der Ansprüche 1 bis 11, **dadurch gekennzeichnet, dass** die auf dem Substrat (16) abgeschiedene Schicht (22) getempert wird.

**13.** Verfahren nach Anspruch 12, **dadurch gekennzeichnet, dass** das Tempern der Schicht (22) bei einer Temperatur im Bereich von 200° C bis 1000° C erfolgt.

**Claims**

**1.** Method for producing thermoelectric layers by depositing thermoelectric material on a substrate by means of sputter deposition, **characterised by**

- the manufacture of a target made of thermoelectric material by mixing at least two starting materials (1, 2) in powder form in a particle size of 0.01 $\mu$m - 5000.00 $\mu$m under energy coupling by means of mechanical alloying or by means of plasma alloying and
- the deposition of the thermoelectric material from the target (3) on the substrate by means of magnetron sputter deposition, wherein a magnetic field is superimposed on the electrical field generated by a target cathode (19) and an anode (20) and a direct current gas discharge between the target cathode (19) and the anode (20) serves as an ion source.

**2.** Method according to claim 1, **characterised in that** for manufacturing the target (3) at least two different starting materials (1, 2) from one of the following groups of starting materials are mixed:

- $Bi_2Te_3$, $Bi_2Se_3$, $Sb_2Te_3$

- Pb, Te
- Si, Ge
- carbides
- perovskites
- clathrates
- skutterudites
- nitrides
- Zintl phases
- Half-Heusler compounds
- carbon-based semiconductors and
- metal oxides.

3. Method according to claim 2, **characterised in that** for manufacturing a p-type target (3) the starting materials $Sb_2Te_3$ and $Bi_2Te_3$ are mixed, wherein the p-type target has 60 - 90 mol % designation $Sb_2Te_3$.

4. Method according to claim 2, **characterised in that** for manufacturing an n-type target (3) the starting materials designation $Bi_2Se_3$ and $Bi_2Te_3$ are mixed, wherein the n-type target has 80 - 95 mol % $Bi_2Se_3$.

5. Method according to claim 2, **characterised in that** for manufacturing an n-type target (3) the n-type doped starting materials silicon and germanium are mixed.

6. Method according to claim 2, **characterised in that** for manufacturing an p-type target the p-type doped starting materials silicon and germanium are mixed.

7. Method according to any of claims 1 to 6, **characterised in that** the manufacture of the target (3) from thermoelectric material comprises following steps:

   - grinding the at least two starting materials (1, 2) in powder form,
   - removing the starting materials alloyed by the grinding and
   - subsequent sintering of the alloyed starting materials at temperatures in a range of 200 to 1000°C.

8. Method according to claim 7, **characterised in that** the at least two starting materials (1, 2) in powder form are ground in a grinding bead mill (4).

9. Method according to any of claims 1 to 6, **characterised in that** the manufacture of the target from thermoelectric material comprises following steps:

   - introducing the at least two starting materials (1, 2) in powder form into a gas stream (14),
   - generating a cold atmospheric plasma in a gas jet (6),
   - feeding in the gas stream (14) into the gas jet (6) and
   - depositing the starting materials (1, 2) on a carrier.

10. Method according to claim 9, **characterised in that** the cold atmospheric plasma has a temperature below 1000°C.

11. Method according to claim 9 or 10, **characterised in that** mass flow of the starting materials (1, 2) in the gas stream is in the range of 0.01 - 200 g/sec $cm^2$.

12. Method according to any of claims 1 to 11, **characterised in that** the layer (22) deposited on the substrate (16) is annealed.

13. Method according to claim 12, **characterised in that** the tempering of the layer (22) takes place at a temperature in the range of 200°C to 1000°C.

**Revendications**

1. Procédé de production de couches thermoélectriques par séparation de matériau thermoélectrique sur un substrat par dépôt par pulvérisation, **caractérisé par**

- la production d'une cible en matériau thermoélectrique par mélange d'au moins deux matériaux de départ (1, 2) pulvérulents d'une taille de particule de 0,01 $\mu$m - 5000,00 $\mu$m par injection d'énergie par alliage mécanique ou par alliage plasma ainsi que

- la séparation du matériau thermoélectrique de la cible (3) sur le substrat par dépôt par pulvérisation magnétron, dans lequel un champ magnétique recouvre le champ électrique généré par une cathode cible (19) et une anode (20) et une décharge de gaz de courant continu entre la cathode cible (19) et l'anode (20) sert de source d'ions.

**2.** Procédé selon la revendication 1, **caractérisé en ce que** pour la production de la cible (3) au moins deux matériaux de départ (1, 2) différents d'un des groupes suivants de matériaux de départ sont mélangés :

- $Bi_2Te_3$, $Bi_2Se_3$, $Sb_2Te_3$,
- Pb, Te
- Si, Ge,
- carbure,
- perovskite
- clathrate
- skutterudite
- nitrure,
- phases de Zintl,
- liaisons Half-Heusler,
- semi-conducteurs à base de carbone et
- oxydes métalliques.

**3.** Procédé selon la revendication 2, **caractérisé en ce que** pour la production d'une cible de type p (3), les matériaux de départ $Sb_2Te_3$ et $Bi_2Te_3$ sont mélangés, dans lequel la cible de type p présente 60 - 90 % en mole de désignation $Sb_2Te_3$.

**4.** Procédé selon la revendication 2, **caractérisé en ce que** pour la production d'une cible de type n (3), les matériaux de départ de désignation $Bi_2Se_3$ et $Bi_2Te_3$ sont mélangés, dans lequel la cible de type n présente 80 - 95 % en mole de $Bi_2Se_3$.

**5.** Procédé selon la revendication 2, **caractérisé en ce que** pour la production d'une cible de type n, les matériaux de départ dotés de type n silicium et germanium sont mélangés.

**6.** Procédé selon la revendication 2, **caractérisé en ce que** pour la production d'une cible de type p, les matériaux de départ dotés de type p silicium et germanium sont mélangés.

**7.** Procédé selon l'une quelconque des revendications 1 à 6, **caractérisé en ce que** la production de la cible (3) en matériau thermoélectrique comprend les étapes suivantes :

- broyage des au moins deux matériaux de départ (1, 2) pulvérulents,
- retrait des matériaux de départ alliés par le broyage et
- frittage subséquent des matériaux de départ alliés à des températures dans la plage de 200 - 1000 °C.

**8.** Procédé selon la revendication 7, **caractérisé en ce que** les au moins deux matériaux de départ (1, 2) pulvérulents sont broyés dans un moulin de corps de broyage (4).

**9.** Procédé selon l'une quelconque des revendications 1 à 6, **caractérisé en ce que** la production de la cible en matériau thermoélectrique comprend les étapes suivantes :

- introduction des au moins deux matériaux de départ (1, 2) pulvérulents dans un flux de gaz (14),
- génération d'un plasma atmosphérique froid dans un jet de gaz (6),
- alimentation du flux de gaz (14) dans le jet de gaz (6) et
- séparation des matériaux de départ (1, 2) sur un support.

**10.** Procédé selon la revendication 9, **caractérisé en ce que** le plasma atmosphérique froid présente une température inférieure à 1000 °C.

**11.** Procédé selon la revendication 9 ou 10, **caractérisé en ce que** le débit massique des matériaux de départ (1, 2) dans le flux de gaz se trouve dans la plage de 0,01 - 200 g/s cm$^2$.

**12.** Procédé selon l'une quelconque des revendications 1 à 11, **caractérisé en ce que** la couche (22) séparée sur le substrat (16) est trempée.

**13.** Procédé selon la revendication 12, **caractérisé en ce que** la trempe de la couche (22) a lieu à une température dans la plage de 200 °C à 1000 °C.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10122679 A1
- WO 2007042255 A1
- EP 1737053 A1
- US 2006063291 A1